Europäisches Patentamt

European Patent Office

Office européen des brevets

(11) Veröffentlichungsnummer: **0 471 936 B1**

(12) **EUROPÄISCHE PATENTSCHRIFT**

(45) Veröffentlichungstag der Patentschrift: **28.09.94**

(51) Int. Cl.5: **D04H 1/64**, D04H 1/58

(21) Anmeldenummer: **91109776.4**

(22) Anmeldetag: **14.06.91**

(54) **Abdeckfolie für flexible Leiterplatten.**

(30) Priorität: **21.08.90 DE 4026353**

(43) Veröffentlichungstag der Anmeldung:
**26.02.92 Patentblatt 92/09**

(45) Bekanntmachung des Hinweises auf die
Patenterteilung:
**28.09.94 Patentblatt 94/39**

(84) Benannte Vertragsstaaten:
**AT BE CH DE DK ES FR GB GR IT LI LU NL SE**

(56) Entgegenhaltungen:
**EP-B- 0 052 562**
**DE-A- 3 200 072**
**US-A- 4 291 087**
**US-A- 4 386 131**

(73) Patentinhaber: **Firma Carl Freudenberg**
**Höhnerweg 2-4**
**D-69469 Weinheim (DE)**

(72) Erfinder: **Kober, Horst**
**Berggewann 5**
**W-6940 Weinheim-Oberflockenbach (DE)**
Erfinder: **Kuhlmann, Thomas, Dr.**
**Werderplatz 9**
**W-6900 Heidelberg (DE)**
Erfinder: **Hausdorf, Jörg**
**Bahnstrasse 6**
**W-6942 Mörlenbach (DE)**
Erfinder: **Kosack, Steffen, Dr.**
**Neustadter Strasse 75**
**W-6733 Hassloch (DE)**
Erfinder: **Schäfer, Werner**
**Carl-Diem-Strasse 11**
**W-6943 Birkenau (DE)**
Erfinder: **Siekermann, Volker, Dr.**
**Erich-Kästner-Strasse 1**
**W-6149 Fürth (DE)**

**Beschreibung**

Die Erfindung betrifft die Verwendung eines beschichteten und imprägnierten Vliesstoffs oder Papiers als Abdeckfolie für flexible Leiterplatten.

Auf das Leiterbild von flexiblen Leiterplatten wird eine Deckfolie aufgebracht. Diese isoliert die Leiterzüge, schützt das Leiterbild vor Verschmutzung, Korrosion und mechanischer Beschädigung und ist zudem zur Ausbildung eines symmetrischen Lagenaufbaus und/oder als Lötstoppmaske erforderlich.

Herkömmliche Deckfolien bestehen aus Polyester oder Polyimid. In sie sind Löcher gebohrt oder gestanzt, damit die Lötaugen der flexiblen Leiterplatten freibleiben. Die Deckfolie wird unter Druck und Wärme mittels einer wärmeaktivierbaren Kleberbeschichtung auf die flexible Leiterplatte gepreßt.

Nachteilig dabei ist, daß diese Kleber beim Verpressen fließen und die Löcher in der Deckfolie verengen, so daß sich die darunterliegende Lötfläche verkleinert. Die Größe des Kleberauslaufs läßt sich nur schwer steuern, da er unter anderem vom Zustand des Klebers bezüglich Polymerisationsgrad und Anteil flüchtiger Bestandteile abhängt.

Verwendet man für die Deckfolie einen nichtfließenden Kleber, dann besteht die Gefahr, daß die Luft zwischen den Leiterbahnen nicht restlos verdrängt werden kann und das Lot beim Heißverzinnen oder bei der Lötung die Deckfolie unterwandert. Die Kleber für die Deckfolie müssen durch zusätzliche Flammschutzmittel selbstverlöschend ausgestaltet werden.

Der Erfindung liegt die Aufgabe zugrunde, eine kleberfreie Deckfolie zu entwickeln, deren Öffnungen gebohrt oder gestanzt werden können, die blasenfrei laminiert werden kann und die bei Heißverzinnungsprozessen oder Lötungen nicht zur Lötunterwanderung neigt. Die Folie muß selbstverlöschend ausgerüstet sein, jedoch ohne Einsatz von halogenierten Flammschutzmitteln. Die Verbindung der Deckfolie mit der Leiterplatte muß eine Schälfestigkeit über 0,4 N/mm aufweisen, beständig gegen Lötbäder sein (290°C, 20s) und ein Brandverhalten nach UL 94, Klasse V0, erfüllen.

Diese Aufgabe wird gelöst durch die Verwendung des in Anspruch 1 gekennzeichneten, beschichteten und imprägnierten Vliesstoffs oder Papiers.

Das Verhältnis der 50%igen wäßrigen Dispersion des Copolymerisats zu der 60%igen, wäßrigen, Methylolgruppen enthaltenen Lösung eines Aminoplast-Vorkondensats muß sich (trocken) zwischen 10:0,8 und 10:2,0 bewegen, um eine chemisches Vernetzungsprodukt zu erhalten; ein höherer Anteil des Vorkondensats führt zu spröden Beschichtungen und neigt zu Blasenbildung, während eine Erniedrigung zu einer zu geringen Vernetzungsdichte führt.

Um die geforderte flammhemmende Eigenschaft nach UL 94 (Klasse V0) zu erfüllen, wird dem Vernetzungssystem eine feindisperse Flammschutzmischung auf Basis roter Phosphor und Ammoniumpolyphosphat (Verhältnis 1:10) in einem Verhältnis von 1:0,9 zugesetzt. Die Korngröße des roten Aus dem Stand der Technik sind mit Copolymerisat-Dispersionen imprägnierte Vliesstoffe für andere Anwendungsbereiche bekannt:

So beschreibt DE-A1 3 200 072 ein Verfahren zur Herstellung tiefziehbarer Nadelvliese für Kraftfahrzeug-Innenausstattungen mit in tiefgezogenem Zustand verminderter Neigung zum Schrumpfen in der Wärme. Die verwendete Copolymerisat-Dispersion enthält Latexteilchen, welche aus zwei Phasen bestehen, deren Glastemperaturen sich um mindestens 40°C unterscheiden und deren Mengenverhältnis von 20:80 bis 80:20 beträgt. Eine Phase besteht aus Styrol, gegebenenfalls im Gemisch mit bis zu 50% seines Gewichts an Acrylnitril und bis zu 10 Gew.-% einer ungesättigten Monocarbonsäure und/oder ihres Amids. Die andere Phase wird gebildet aus einem Gemisch von 20 bis 70 Gew.-% des Gemisches Butadien und 30 bis 80 Gew.-% Styrol, Acrylnitril und/oder (Meth)acrylsäurealkylester mit 1 bis 20 C-Atomen im Alkylrest, das bis zu 10% dieses zweiten Gemisches an einer monoolefinisch ungesättigten Monocarbonsäure und/oder deren Amid enthält. Das Copolymerisat wird in einer zweistufigen Emulsions-Copolymerisation hergestellt.

EP-B1-0 052 562 befaßt sich mit Vliesstoffen für hygienische Zwecke, welche mit einem Bindemittel fixiert sind, das zusammengesetzt ist aus einem Copolymeren A aus Butadien, Styrol und zumindest einer ethylenisch ungesättigten Carbonsäure, und aus einem Polymeren B auf der Basis von Vinylphosphonat, welches zumindest teilweise auf das Copolymere A gepfropft ist. Das Polymere B kann zusätzlich 0 bis 85 Gew.-% Arcylnitril enthalten.

US-A 4 291 087 offenbart strahlenhärtbare, imprägnierte Vliesstoffe für vielfältige Anwendungen in Haushalt, Gewerbe und Industrie. Die Imprägnierung besteht aus einem polymeren Binder, der abgeleitet ist aus einer Monomeren-Mischung. Die Monomeren können ausgewählt werden aus der Gruppe der Acryl- und Methacryl-Säuren sowie Ester-Amid- und Nitril-Derivaten davon aus Vinylaromaten, aus Vinyl- und Vinyliden-Halogeniden, aus Vinylestern gesättigter Carboxylsäuren, polymerisierbaren, etylenisch ungesättigten Carboxylsäuren und deren Estern, aus Alpha-Olefinen und Dien-Monomeren.

Über Anforderungen, welche die Abdeckfolien für flexible Leiterplatten zu erfüllen haben, wird in diesem Stand der Technik nichts ausgesagt.

Phosphors bewegt sich zwischen 0,045 und 0,10 mm, diejenige des Ammoniumpolyphosphats zwischen 0,025 und 0,075 mm. Eine höhere oder niedrigere Phophorkonzentration, als angegeben, führt zu Beschichtungen, die die Anforderungen an UL 94 V0 nicht mehr erfüllen; ebenso ist eine feindisperse Verteilung der Flammschutzmischung im Vernetzungssystem notwendig.

Die eingangs charakterisierten Komponenten werden zweckmäßig in einem Rührwerk vermischt; die Beschichtung bzw. Imprägnierung kann gleich gut durch Bürsten, Rakeln, Streichen oder Drucken erfolgen. Es werden Vlieszuschnitte hergestellt oder entsprechende Bahnenware beschichtet, bei 100 bis 120°C getrocknet und anschließend unter Druck und Wärme mit der flexiblen Leiterplatte haftend verbunden.

Die Rohstoffe für die Dispersion sind im Handel erhältlich: Die Komponente a), die 50%ige wäßrige Dispersion des thermisch vernetzbaren Copolymerisats mit einer Glasübergangstemperatur von + 33°C aus Acrylnitril und Styrol z.B. unter der Bezeichnung Acronal S 886 S (BASF), die Komponente b), die 60%ige, wäßrige, Methylolgruppen enthaltende Lösung eines Amino- oder Phenoplast-Vorkondensats, unter der Bezeichnung Casurit F (Hoechst), der rote Phosphor mit einer Korngröße von 0,045 bis 0,10 mm (Komponente c)) unter der Bezeichnung Exolit 405 (Hoechst) sowie das Ammoniumpolyphosphat (Korngröße von 0,025 bis 0,075 mm) unter der Bezeichnung Exolit 422 (Hoechst).

Die Eignung der Einzelkomponenten a) und b) getrennt voneinander für Beschichtungs-, Kaschier- und Klebezwecke ist bekannt. Unvorhersehbar war jedoch, daß die kombinierte Verwendung dieser Mischungsbestandteile, in Verbindung mit dem halogenfreien Flammschutzsystem, bei der Beschichtung und Imprägnierung auf Vliesstoff oder Papier - nach der Vernetzung - zu einem Material führt, das die Vielfalt der Anforderungen an Deckfolien von flexiblen Leiterplatten, wie z.B. Lötbadbeständigkeit, Brandverhalten, Schälfestigkeit zur Leiterplatte, nach IPC-Norm erfüllt.

Das Beschichtungssystem ist wäßriger Natur und enthält keine halogenhaltigen Flammschutzmittel; es entfallen somit Schutz- und Entsorgungsmaßnahmen, wie sie bisher beim Einsatz von Lösungsmitteln und halogenhaltigen Flammschutzmitteln erforderliche waren.

Die Auftragsmenge soll 30 bis 60 g/m$^2$ (trocken) betragen. Bei Raumtemperatur sind Trocknungszeiten von lediglich etwa 10 Minuten erforderlich. Ein weiterer Vorteil liegt in der Tatsache, daß das beschichtete und getrocknete Vlies oder Papier vor der Herstellung des Verbundes wochenlang lagerfähig ist, ohne daß das Beschichtungssystem seine vorteilhaften Qualitäten und Wirkungen einbüßt.

Die folgenden Beispiele zeigen typische Eigenschaften des Verbundes einer Leiterbahnen tragenden Seite einer flexiblen Leiterplatte mit einem erfindungsgemäß beschichteten und imprägnierten Vliesstoff. Der reine Vliesstoff besitzt dabei die folgende Spezifikation:

| Polyamid-Polyester-Bindefaserbeimischung | |
|---|---|
| Flächengewicht: | 49 g/m2 |
| Dicke: | 0,071 mm |
| Höchstzugkraft: | 134 N |
| Dehnung: | 24 % |
| Luftdurchlässigkeit: | 207 dm3/s/m2 |

Die 50%ige, wäßrige Dispersion eines thermisch vernetzbaren Copolymerisats mit einer Glasübergangstemperatur von + 33°C aus Acrylnitril und Styrol und die 60%ige, wäßrige, Methylolgruppen enthaltende Lösung eines Amino- oder Phenoplast-Vorkondensats werden zusammen mit dem oben spezifizierten roten Phosphor, Komponente c), und dem feinteiligen Ammoniumpolyphosphat, der Komponente d), in einem schnellaufenden Rührwerk vermischt. Der oben charakterisierte Vliesstoff wird durch Rakeln mit der Beschichtung versehen in einer Menge von 40 g/m$^2$ (trocken). Es werden Vlieszuschnitte hergestellt, bei 110°C 10 Minuten lang getrocknet und anschließend bei 200°C unter Druck in einer Presse mit der flexiblen Leiterplatte haftend verbunden. Die folgende Tabelle zeigt 5 Variationen der Mischungsbestandteile und die beobachteten Versuchsergebnisse:

3

T A B E L L E

| Beispiele | 1 | 2 | 3 | 4 | 5 |
|---|---|---|---|---|---|
| Copolymerisat aus Acrylnitril u. Styrol, 50%ige Dispersion, Komponente a) | 200 | 200 | 200 | 200 | 200 |
| Melaminharzformaldehyd-Vorkondensat, Komponente b) | 20 | 20 | 20 | – | 40 |
| Exolit 405, Komponente c) | 8 | 12 | 5 | 8 | 8 |
| Exolit 422, Komponente d) | 10 | 10 | 10 | 10 | 10 |
| Wasser | 90 | 90 | 90 | 90 | 90 |
| Farbstoff Luconyl-blau (BASF) | 10 | 10 | 10 | 10 | 10 |
| Schälfestigkeit (Deckfolie/Leiterplatte) (N/mm) | $>0,4$ | $>0,4$ | $>0,4$ | $<0,4$ | $>0,4$ |
| Lötbadbeständigkeit bei 290°C, 20 s | erfüllt | erfüllt | erfüllt | nicht erfüllt | erfüllt |
| Brandverhalten nach UL 94 | V0 | * | * | V0 | V0 |
| Oberfläche nach dem Verpressen | glatt | glatt | glatt | glatt | Blasen |

* UL 94 V0 nicht erfüllt

Die Zahlenangaben bedeuten, wenn nicht anders angegeben, Gewichtsteile.

Die gemessenen und beobachteten Daten aus der vorstehenden Tabelle belegen, daß die Verwendung eines erfindungsgemäß beschichteten und imprägnierten Vliesstoffs alle in der Aufgabenstellung genannten Anforderungen voll erfüllt.

**Patentansprüche**

1. Verwendung eines Vliesstoffs oder Papiers, welches beschichtet und imprägniert ist mit dem chemischen Vernetzungsprodukt aus

   a) der 50%igen, wäßrigen Dispersion eines thermisch vernetzbaren Copolymerisats mit einer Glasübergangstemperatur von + 33°C aus Acrylnitril und Styrol und aus

   b) der 60%igen, wäßrigen, Methylolgruppen enthaltenden Lösung eines Amino- oder Phenoplast-Vorkondensats, in Verbindung mit

c) rotem Phosphor mit einer Korngröße von 0,045 bis 0,10 mm und

d) Ammoniumpolyphosphat mit einer Korngröße von 0,025 bis 0,075 mm, wobei die Auftragsmenge (trocken) 30 bis 60 g/m$^2$ beträgt, als Abdeckfolie für flexible Leiterplatten, wobei das Verhältnis a:b (trocken) 10:0,8 bis 10:2,0, dasjenige von c:d 1:10 und das aus (a + b) und (c + d) 1:0,9 beträgt.

## Claims

**1.** The use of a nonwoven material or paper which has been coated and impregnated with the chemical cross-linking product of

a) the 50%, aqueous dispersion of a thermally cross-linkable acrylonitrile-styrene copolymer having a glass transition temperature of + 33 °C and

b) the 60%, aqueous, methylol group-containing solution of an amino or phenolic resin precondensate, in combination with

c) red phosphorus having a particle size of from 0.045 to 0.10 mm, and

d) ammonium polyphosphate having a particle size of from 0.025 to 0.075 mm,

at an application rate (dry) of from 30 to 60 g/m$^2$, as a cover film for flexible circuit boards, where the a:b ratio (dry) is from 10:0.8 to 10:2.0, the c:d ratio is 1:10 and the (a + b):(c + d) ratio is 1:0.9.

## Revendications

**1.** Utilisation d'une étoffe non tissée ou d'un papier qui est enduit(e) et imprégné(e) avec le produit chimique réticulé composé de

a) la dispersion aqueuse à 50% d'un copolymère réticulable sous l'effet de la chaleur, ayant une température de transition vitreuse de + 33 C, composé d'acrylnitrile et de styrène et de

b) la solution aqueuse à 60%, contenant des groupes méthylol, d'un précondensat amino ou de phénoplaste, en liaison avec

c) du phosphore rouge pourvu d'une grosseur de grains de 0,045 à 0,10 mm et

d) du polyphosphate d'ammonium pourvu d'une grosseur de grains de 0,025 à 0,075 mm,

quantitée appliquée (sèche) étant de 30 à 60 g/m$^2$, cette étoffe non tissée ou ce papier servant de feuille de protection pour des plaques flexibles de circuit, la proportion a:b (sèche) étant de 10:0,8 jusqu'à 10:2,0, celle de c:d étant de 1:10 et celle de (a + b) par rapport à (c + d) étant de 1:0,9.